# EUROPEAN PATENT SPECIFICATION

(11) **EP 0 698 006 B1**
(45) Date of publication and mention of the grant of the patent: **08.10.1997**
(21) Application number: 94910487.1
(22) Date of filing: 28.03.1994
(51) Int. Cl.: C06B 45/14, C23C 14/14

(54) **PYROTECHNIC MATERIAL**
PYROTECHNISCHE MATERIALEN
MATERIAU PYROTECHNIQUE

(30) Priority: 15.04.1993 GB 9307846
(43) Date of publication of application: 28.02.1996
(73) Proprietor: SECRETARY OF STATE FOR DEFENCE IN HER BRITANNIC MAJESTY'S GOV. OF THE UNITED KINGDOM OF GREAT BRITAIN AND NORTHERN IRELAND, Farnborough, Hampshire GU14 6TD (GB)
(72) Inventor: TINSTON, Stephen, Fredrick Intellectual Property, Farnborough Hampshire GU14 6TD (GB); KELLY, Peter, James Intellectual Property Dept.,, Hampshire GU14 6TD (GB); HAMMANT, Brian, Leslie Intellectual Property Dept, Hampshire GU14 6TD (GB); PLACE, Malcolm, Stewart Intellectual Property Dpt, Hampshire GU14 6TD (GB)
(74) Representative: Beckham, Robert William
(86) International application number: GB9400640
(87) International publication number: WO9424074

(56) References cited:
- EP-A- 0 487 472
- FR-A- 2 274 579
- GB-A- 1 101 106
- GB-A- 2 224 729
- US-A- 3 167 628
- US-A- 4 539 054
- US-A- 4 783 379
- MATERIALS LETTERS, vol.6, no.8-9, May 1988, AMSTERDAM,NL pages 311 - 315 QING-MING CHEN ET AL. 'Amorphization of binary alloys by magnetron cosputtering'
- JOURNAL OF PHYSICS D. APPLIED PHYSICS, vol.19, no.7, July 1986, LONDON, UK pages 1245 - 1255 R. MOHAMMED IDRUS ET AL. 'The crystallisation of CoZr amorphous alloys in the range Co92Zr8 to Co21Zr79'

## Description

This invention relates to pyrotechnic materials, and in particular to pyrotechnic trains suitable for use in single- or multi-train delay systems, ignition and detonation transfer, and to methods of their manufacture.

Conventional pyrotechnic devices are generally manufactured from granular pyrotechnic compositions consisting of intimate mixtures of finely divided particles of materials selected and mixed to produce the desired burning rates. Delay systems are typically constructed by packing such particulate compositions into lead tubes. These may then be fine drawn to produce delay cords suitable for incorporation into a pyrotechnic train assembly.

Such a process is cumbersome, expensive, potentially hazardous and requires clean room assembly. Furthermore, granular pyrotechnic compositions are subject to a number of problems which can produce variations in performance, such as batch-to-batch variation, moisture adsorption, and the presence of native surface oxide layers on the reactant particles.

UK Patent 2224729 discloses that these problems can be mitigated by vapour depositing a pyrotechnic composition onto a substrate in the form of alternate layers of coreactive materials. The material thus produced has improved inherent strength and the surface oxide layer is absent, so that more consistent reaction rates are achievable than with granular compositions.

However, the multilayer material still contains discrete phases of its constituent pyrotechnic materials where the reaction takes place only at the interface between the discrete phases. In both particulate and multilayer systems the reaction rate is therefore governed by diffusion of material to the interface. This is the governing factor in reaction rate and places an upper limit on individual layer thickness if the reaction is to remain self sustaining.

It is known to deposit partly amorphous binary alloys of iron or titanium by magnetron cosputtering (Materials Letters, vol.6, nos.8-9, May 1988, Amsterdam, NL, pages 311-315, Qing-Ming Chen et al.), however this has not been applied to pyrotechnic compositions.

It is an object of the present invention to provide a pyrotechnic material which mitigates the above disadvantages, and which aims to provide more rapid rates of propagation, and greater sustainability of propagation through the material, than existing pyrotechnic systems.

It is a further object of the present invention to provide a method of manufacture for such materials which is amenable to mechanization, and which enables the relative proportions of constituent pyrotechnic materials to be readily controlled and novel constituent pyrotechnic materials and novel exothermic processes to be exploited.

Thus according to a first aspect of the present invention there is provided a pyrotechnic material comprising at least two different materials concurrently vapour deposited so as to produce a single phase largely disordered structure wherein the at least two different materials are conjointly capable of undergoing a self-sustaining exothermic process, whereby a more ordered structure is produced, when subjected to heat.

Heating the material provides the necessary energy input to overcome thermodynamic barriers to the transition from the largely disordered structure produced by codepositing the component materials to a more ordered structure, thereby initiating the transition reaction. Constituent materials are selected so that the exothermic nature of the transition provides sufficient further energy for the transition to be self sustaining. A number of appropriate means of heating will be known to those skilled in the pyrotechnic art; for example application of an electric current, direct heating from a flame or second pyrotechnic material, laser heating, friction, shock, microwaves.

The invention is applicable to a number of conventional pyrotechnic material combinations, that is, combinations where the at least two different materials are conjointly capable of undergoing a self-sustaining exothermic chemical reaction when subjected to heat. For simplicity, the pyrotechnic material preferably comprises two different materials, which function respectively as an electron donor material and an electron acceptor material during the pyrotechnic reaction.

The process of concurrent vapour deposition is able to produce a single phase energetic layer, albeit one with a semi-amorphous structure exhibiting limited long range ordering, where the two reactive materials are in intimate proximity on an atomic scale. There is thus no requirement for bulk diffusion of material to a reaction site such as is common to all prior art systems and once initiated the reaction consequently proceeds at a much more rapid rate than in existing materials of equivalent composition. The reaction can propagate in three dimensions, which helps ensure that it is sustained as it proceeds through the pyrotechnic material.

The invention is not readily applicable to the thermite (metal/ metal oxide) class of pyrotechnic compositions as codeposition of these materials presents considerable practical difficulties. These pyrotechnic compositions require reactive constituents comprising a distinct metal component and a distinct metal oxide component, which is most readily achieved by retaining two distinct phases in the material. However, it is particularly applicable to materials which form intermetallic reaction products (which will be understood by those skilled in the art to include compositions where the electron acceptor material is boron, carbon, silicon or germanium). An example is transition metal type compositions consisting of a transition metal as an electron donor and an element from Group IIIB or IVB (IUPAC notation) as an electron acceptor. This class of pyrotechnic compositions undergoes a highly exothermic, virtually gasless solid-state reaction to form intermetallic products.

Thus the composition of the pyrotechnic material is preferably one where the electron donor material is a transition metal and the electron acceptor material is selected from materials contained in Groups IIIB and IVB (IUPAC notation) of the periodic table.

It is an advantage of the present invention that it is not restricted to conventional pyrotechnic material constituents, where a self-sustaining exothermic chemical reaction occurs. Because the pyrotechnic material is deposited in a partly amorphous, disordered structure the invention allows exploitation of the exothermic character of physical processes which produce an increase in structural order for pyrotechnic purposes. For example, deposition of two or more elements in a ratio corresponding to a stable alloy composition produces a layer having an unstable structure in which the different component materials are in intimate contact at an atomic level but not truly in solid solution. Such materials when subjected to heat to provide the energy to initiate the transformation may undergo a self-sustaining transition to a true alloy state, where the energy to sustain the transition derives from the heat of solution of the particular composition.

The first aspect of the present invention therefore also provides for a pyrotechnic material wherein the at least two different materials are conjointly capable of undergoing a self-sustaining exothermic physical transition to a more ordered lattice structure when subjected to heat, and in particular wherein the at least two different materials comprise a first material and at least one other material soluble in the first material in the solid state.

The pyrotechnic material may further comprise a substrate whereon the at least two different materials are deposited. The substrate may be of an inert or reactive material. The use of a substrate is particularly appropriate in applying the invention to pyrotechnic trains, which can be comprised of a pyrotechnic layer deposited on the substrate in an appropriate configuration.

Thus according to a further aspect of the invention there is provided a pyrotechnic train including pyrotechnic material as described above. Propagation rates up to 100 times those for trains made up of conventional compositions have been obtained, and good consistency of reaction propagation along the full length of the pyrotechnic train is achieved.

According to a further aspect of the invention there is provided a method of manufacture of the pyrotechnic material above described comprising the steps of selecting at least two different materials which are conjointly capable of undergoing a self-sustaining exothermic process when subjected to heat and concurrently vapour depositing the at least two different materials onto a substrate. The at least two different materials are preferably vapour deposited by unbalanced magnetron sputtering.

According to a further aspect of the invention there is provided a method of manufacture of a pyrotechnic train comprising the method of manufacture of a pyrotechnic material above described and the further step of selectively etching the deposited energetic layer such that the remaining regions thereof provide a desired configuration of reaction paths on the substrate.

Alternatively there is provided a method of manufacture of a .pyrotechnic train comprising the method of manufacture of a pyrotechnic material above described and the further step of selectively masking the substrate prior to depositing the energetic layer so as to provide a desired configuration of reaction paths on the substrate through the masking.

Both of the above embodiments enable straightforward, rapid production of pyrotechnic trains of simple or complex configuration. The method is readily susceptible to mechanisation to allow cheap mass production.

Embodiments of the invention and methods of manufacture will now be described by way of example only with reference to figures 1 to 9 in which:
Figure 1 is a plan view of an example of a planar pyrotechnic delay train comprising pyrotechnic material according to the invention;
Figure 2 is a cross section through A-A of the pyrotechnic material of figure 1;
Figure 3 is a plan view of an example of a planar pyrotechnic multi-train comprising the pyrotechnic material of figure 2;
Figure 4 illustrates graphically an X-ray diffraction analysis of the pyrotechnic material of figure 2 before and after the pyrotechnic reaction;
Figure 5 illustrates graphically an X-ray diffraction analysis of a prior art multilayer pyrotechnic material of equivalent composition before and after the pyrotechnic reaction;
Figure 6 is a cross section of an alternative embodiment of pyrotechnic material according to the invention;
Figure 7 is a plan view of an alternative embodiment of pyrotechnic material according to the invention;
Figure 8 is a plan view of the apparatus used to deposit the energetic layer;
Figure 9 is a cross section through B-B of the apparatus of figure 8.

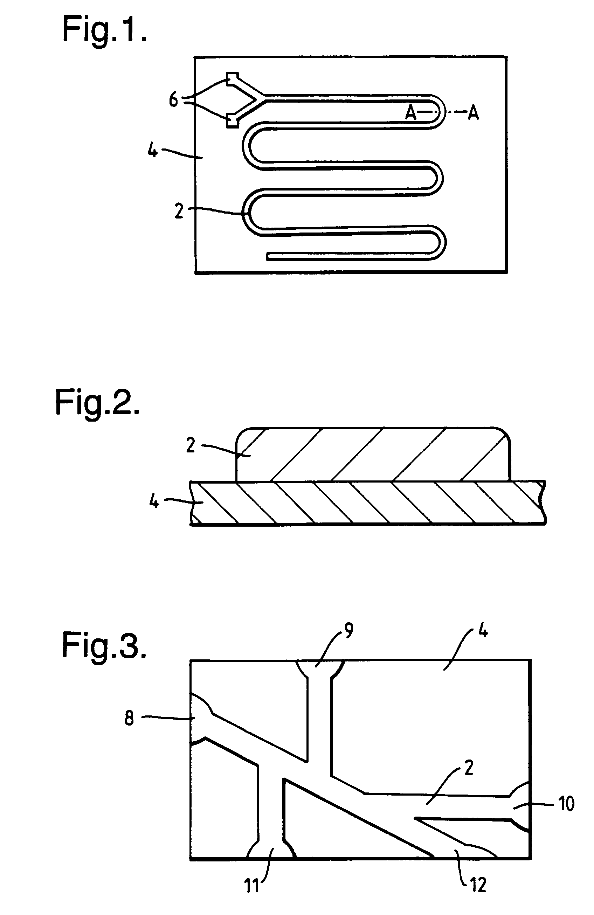

Figure 1 shows a pyrotechnic delay train constituted by a substrate film 4 on which is deposited pyrotechnic material 2 comprising a concurrently vapour deposited mixture of two coreactive materials in appropriate proportions such that a self-sustaining exothermic chemical reaction can be initiated wherein one of the coreactive materials functions as an electron donor and the other as an electron acceptor. The pyrotechnic reaction is initiated in this embodiment by application of a potential difference across the terminals 6, and thereafter proceeds along the delay train. A cross-section through a portion of the material is shown in figure 2.

Many constituent materials will be apparent as appropriate to those skilled in the art, and the following provide examples only. In view of the advantages of compositions incorporating a transition metal and a Group III or IV electron acceptor material, the pyrotechnic material was prepared using Ti/C and Ti/B as constituent pyrotechnic systems. Although titanium and boron produce a more energetic reaction, the sputter rate for boron is very slow, and this necessarily limits the sputter rate of the codeposited layer. More acceptable sputtering rates can be obtained from a carbon source, and the pyrotechnic material discussed below uses titanium as an electron donor and carbon as an electron acceptor as an example which provides a rapid energetic reaction with acceptable sputtering rates.

By codepositing the two constituent elements of the pyrotechnic material a single phase structure may be produced which is in the form of a highly distorted lattice exhibiting limited long range ordering. The constituent coreactive materials are thus in a much more intimate proximity than in existing pyrotechnic materials of equivalent composition so that once the reaction is initiated by application of heat a very rapid reaction occurs producing titanium carbide.

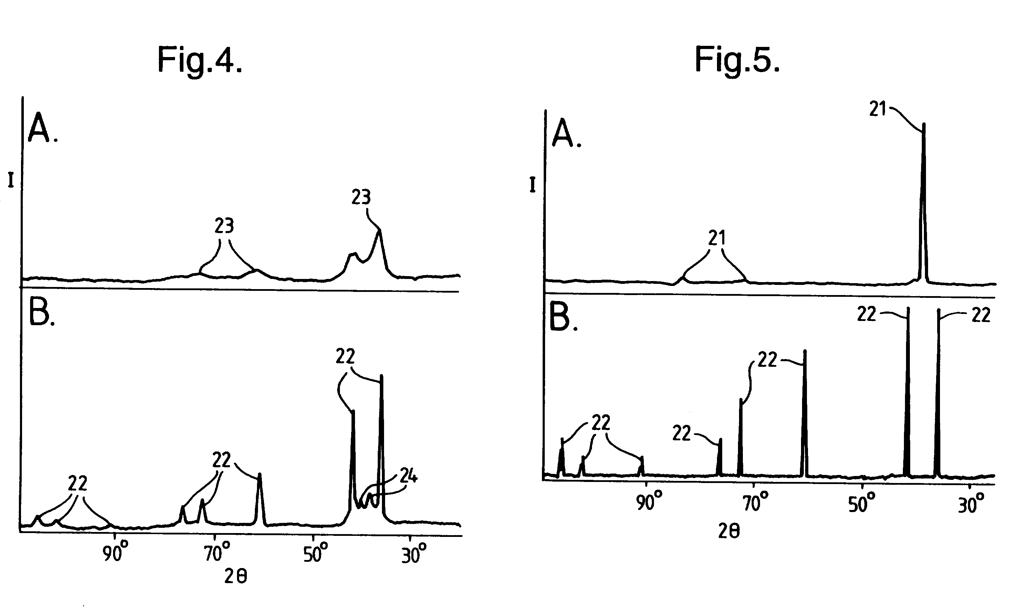

Figures 4 and 5 illustrate this difference, showing X-ray diffraction traces carried out both before reaction (A) and after reaction (B) for the material of figures 1 and 2 and a multilayer titanium/carbon material respectively. In each graph the intensity of the X-ray signal (I) is plotted against the Bragg angle.

On figure 5 prior to reaction clearly defined peaks in intensity 21 are seen corresponding to characteristic peaks for titanium and illustrating that the titanium layers of the multilayer material have a highly ordered lattice structure. The amorphous carbon layers make no contribution to the X-ray diffraction trace. After reaction characteristic peaks 22 are found in the X-ray diffraction trace which correspond to an ordered face centred cubic titanium carbide lattice.

Figure 4 by contrast illustrates only very broad peaks of reduced intensity 23 on the trace prior to reaction (A). These peaks 23 correspond to characteristic reflections for titanium carbide indicating some degree of ordering, but the broadening and reduced intensity indicates that the energetic layer has a highly distorted semi-amorphous structure. This is indicative of a strong degree of intermingling of titanium and carbon on an atomic scale but with relatively little lattice ordering, and is in marked contrast to the strongly crystalline titanium carbide structure illustrated by the peaks 22 on the X-ray diffraction trace from the material after reaction (B). Small peaks 24 are also present indicating the presence of a small quantity of unreacted titanium.

Figure 3 illustrates an alternative application for the pyrotechnic material. A multi-train is shown comprising a film 4 on which is superimposed a network of reactive progression paths of pyrotechnic material 2 comprising codeposited titanium and carbon variously interconnecting and extending into edge terminals 8 to 12. In use a reaction is initiated by an input of energy (electrical, external heat source, friction etc) at one of the terminals, say 8, and the reaction then proceeds along the progression paths at a uniform rate determined by the reaction kinetics of the pyrotechnic to provide an ignition source at the remaining terminals 9 to 12.

The codeposited materials illustrated in figures 1-3 are found to be highly reactive. For example, a coating prepared in accordance with figure 1 is readily ignited by applying a potential difference of 15V at 8A via two electrodes across the terminals 6 and reaction propagation rates of the order of 3ms⁻¹ are obtained. This can be compared with the fastest reported propagation rates for a titanium carbon powder system, which are of the order of 3cms⁻¹. The problems which may be encountered with multilayer materials in getting complete and even propagation along a long train are also found to be much reduced by the increased reactivity and single phase character of the energetic layer.

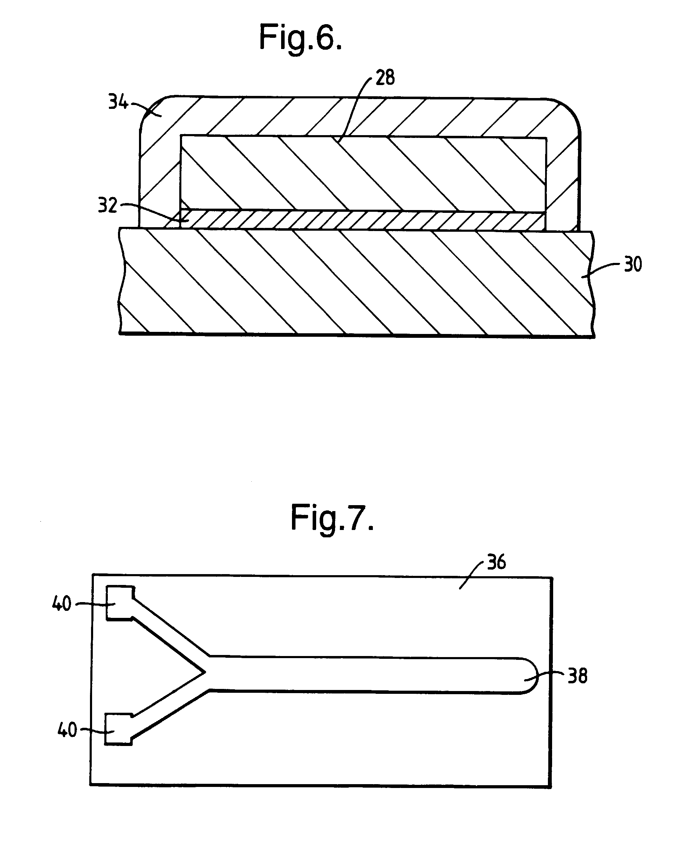

An alternative embodiment of pyrotechnic material according to the invention is illustrated in figure 6 in which is shown a reactive film 28 comprising a codeposited mixture of titanium and carbon on a glass or ceramic substrate 30. In order to improve adhesion of the reactive film 28 a titanium layer 32 approximately 0.5µm in thickness is first deposited directly onto the substrate and the reactive film 28 is subsequently deposited onto the titanium layer 32. This additional layer is found to be useful particularly when apparatus is used to manufacture the pyrotechnic material which does not include a radio frequency bias supply, as adhesion in this case can be a problem. The pyrotechnic material is sealed by a further layer of glass or ceramic 34 of low thermal conductivity so as to minimize diminution of the reaction due to lateral heat loss and concentrate the energy generated by the reaction in the direction of reaction progression.

The embodiment of figure 7 provides an illustration of the pyrotechnic energies achievable in a material produced according to the invention. A layer comprising a concurrently vapour deposited mixture of palladium and aluminium 38 is deposited to a thickness of 4µm onto a substrate which in this embodiment is a lmm thick glass slide 36. This material was found to require a large energy input for initiation: a.c. probes applied to the terminals 40 fail to produce consistent sustained propagation, but the layer 38 may be initiated successfully by microwave radiation. The layer is then found to undergo a very energetic pyrotechnic reaction, sufficient not only to shatter the glass slide 36, but also to produce localised through-thickness melting of the glass.

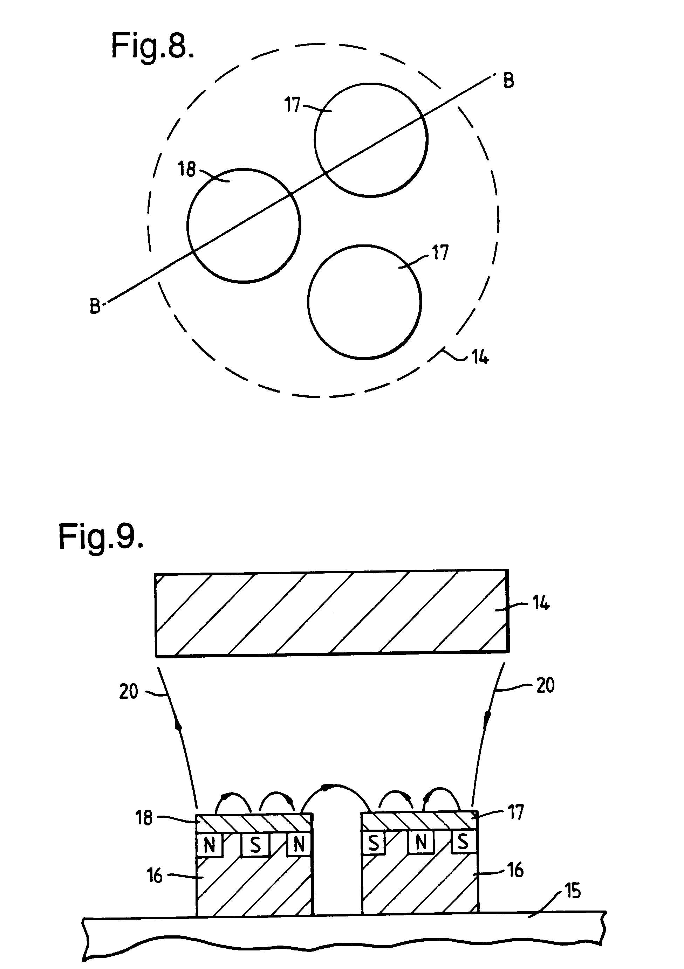

A method of manufacture of the pyrotechnic material according to the invention, and specifically a method of manufacture of the pyrotechnic train of figures 1 and 3, will now be described with reference to figures 8 and 9.

Three 150mm diameter unbalanced magnetrons 16 powered by 5kW dc magnetron drivers are mounted on a base plate 15. A water cooled substrate holder 14 is located above the magnetrons 16. The substrate holder is absent from figure 8 but its position is shown by the broken line. Mounted on each magnetron 16 is a target of carbon 17 or titanium 18 providing the material to be deposited. These are bonded to the magnetrons by means of a conductive adhesive. Good conduction between target and magnetron base plate allows higher powers to be used, increasing deposition rates. This is particularly important for carbon, where sputtering rates are poorer than for most metallic sources. However, it is found, for example, that carbon deposition rates of around 3µm/hour can be achieved from such a conductively bonded target at 1.5kW magnetron power which, although slower than titanium, is of an order of magnitude which makes codeposition feasible. The whole arrangement is contained within a vacuum chamber (not shown).

A face of the substrate 4 is first cleaned and prepared and the substrate 4 then placed on the substrate holder 14. A concurrently deposited layer is obtained by sputtering from all three targets 17, 18 simultaneously and rotating the substrate holder 14 above them. Sputtered material is directed towards the substrate holder under the influence of the field generated by the unbalanced magnetron arrangement, and represented schematically on figure 9 by the field lines 20. A chamber pressure of below 2x10⁻³ Pa should be achieved and an argon atmosphere at 0.3 Pa then introduced. Two carbon targets 17 and one titanium 18 are used to allow for the slower sputtering rate encountered with carbon. The relative proportions of deposited elements can also be adjusted by adjusting the power applied to each target.

In order to manufacture pyrotechnic trains such as are illustrated in figures 1 and 3 a template is prepared having apertures corresponding to the desired progression paths for the pyrotechnic train. This template is used to mask the support plate prior to commencement of the deposition process so that pyrotechnic material is only deposited on those desired progression paths. As an alternative, pyrotechnic material may be deposited onto the entire substrate and the desired network of progression paths then masked with an acid resistant coating. The remaining areas of pyrotechnic are then acid etched away to produce the desired configuration of pyrotechnic train.

It will be apparent to those skilled in the art that selection of alternative materials to those of the above examples and controlling their respective proportions will enable a variety of pyrotechnic materials to be produced in accordance with the invention applicable to a range of pyrotechnic applications and devices, including detonators, igniters, batteries and similar thermal sources.

## Claims

1. A pyrotechnic material comprising at least two different materials concurrently vapour deposited so as to produce a single phase largely disordered structure wherein the at least two different materials are conjointly capable of undergoing a self-sustaining exothermic process, whereby a more ordered structure is produced, when subjected to heat.

2. A pyrotechnic material as claimed in claim 1 wherein the at least two different materials are conjointly capable of undergoing a self-sustaining exothermic chemical reaction when subjected to heat.

3. A pyrotechnic material as claimed in claim 2 comprising two different materials which function respectively as an electron donor material and an electron acceptor material.

4. A pyrotechnic material as claimed in claim 3 wherein the electron donor material is a transition metal and the electron acceptor material is selected from materials of Groups IIIB and IVB (IUPAC notation).

5. A pyrotechnic material as claimed in claim 1 wherein the at least two different materials are conjointly capable of undergoing a self-sustaining exothermic physical transition to a more ordered lattice structure when subjected to heat.

6. A pyrotechnic material as claimed in claim 5 wherein the different materials comprise a first material and at least one other material soluble in the first material in the solid state.

7. A pyrotechnic material as claimed in any preceding claim further comprising a substrate whereon the at least two different materials are deposited.

8. A pyrotechnic train comprising pyrotechnic material as claimed in claim 7.

9. A method of manufacture of the pyrotechnic material of claim 1 comprising the steps of:
selecting at least two different materials which are conjointly capable of undergoing a self-sustaining exothermic process when subjected to heat;
concurrently vapour depositing the at least two different materials onto a substrate.

10. A method of manufacture of a pyrotechnic material as claimed in claim 9 wherein the at least two different materials are vapour deposited by unbalanced. magnetron sputtering.

11. A method of manufacture of a pyrotechnic train comprising the steps of claim 9 or claim 10 and further comprising the step of: selectively etching the deposited reactive layer such that the remaining regions thereof provide a desired configuration of reaction paths on the substrate.

12. A method of manufacture of a pyrotechnic train comprising the steps of claim 9 or claim 10 and further comprising the step of: selectively masking the substrate prior to depositing the reactive layer so as to provide a desired configuration of reaction paths on the substrate through the masking.

## Patentansprüche

1. Pyrotechnisches Material mit wenigstens zwei verschiedenen, gleichzeitig so dampfabgeschiedenen Materialien, um eine stark ungeordnete Einphasenstruktur zu erzeugen, wobei die wenigstens zwei verschiedenen Materialien gemeinsam geeignet sind, einen von selbst ablaufenden exothermen Prozeß durchzumachen, wodurch bei Einwirken von Hitze eine geordnetere Struktur erzeugt wird.

2. Pyrotechnisches Material nach Anspruch 1, wobei die wenigstens zwei verschiedenen Materialien gemeinsam zum Durchmachen einer von selbst ablaufenden chemischen Reaktion bei Einwirken von Hitze geeignet sind.

3. Pyrotechnisches Material nach Anspruch 2, das zwei verschiedene Materialien aufweist, die als ein Elektronenspendermaterial bzw. als ein Elektronenaufnahmematerial wirken.

4. Pyrotechnisches Material nach Anspruch 3, wobei man das Elektronenspendermaterial und das Elektronenaufnahmematerial aus Materialien der Gruppen IIIB und IVB (IUPAC-Bezeichnung) wählt.

5. Pyrotechnisches Material nach Anspruch 1, wobei die wenigstens zwei verschiedenen Materialien gemeinsam zum Durchmachen eines von selbst ablaufenden exothermen physikalischen Übergangs in eine geordnetere Gitterstruktur bei Einwirken von Hitze geeignet sind.

6. Pyrotechnisches Material nach Anspruch 5, wobei die verschiedenen Materialien ein erstes Material und wenigstens ein anderes, im ersten Material im festen Zustand lösliches Material aufweisen.

7. Pyrotechnisches Material nach irgendeinem vorstehenden Anspruch, das außerdem ein Substrrat aufweist, auf dem die wenigstens zwei verschiedenen Materialien abgeschieden sind.

8. Pyrotechnische Kette (train), die pyrotechnisches Material, wie im Anspruch 7 beansprucht, aufweist.

9. Verfahren zur Herstellung des pyrotechnischen Materials nach Anspruch 1, das die Schritte aufweist:
Auswählen wenigstens zweier verschiedener Materialien, die sich gemeinsam zum Durchmachen eines von selbst ablaufenden exopthermen Prozesses bei Einwirkung von Hitze eignen, und
gleichzeitige Dampfabscheidung der wenigstens zwei verschiedenen Materialiien auf einem Substrat.

10. Verfahren zur Herstellung eines pyrotechnischen Materials, wie im Anspruch 9 beansprucht,
wobei die wenigstens zwei verschiedenen Materialien durch unausgeglichene Magnetronzerstäubung dampfabgeschieden werden.

11. Verfahren zur Herstellung einer pyrotechnischen Kette mit den Schritten nach Anspruch 9 oder Anspruch 10, das außerdem den Schritt der: selektiven Ätzung der abgeschiedenen reaktiven Schicht derart aufweist, daß deren verbleibende Bereiche eine gewünschte Konfiguration von Reaktionsbahnen auf dem Substrat vorsehen.

12. Verfahren zur Herstellung einer pyrotechnischen Kette mit den Schritten nach Anspruch 9 oder Anspruch 10, das außerdem den Schritt des: selektiven Maskierens des Substrats vor dem Abscheiden der reaktiven Schicht derart aufweist, um eine gewünschte Konfiguration von Reaktionsbahnen auf dem Substrat durch die Maskierung vorzusehen.

## Revendications

1. Matériau pyrotechnique comprenant au moins deux matières différentes déposées simultanément en phase vapeur de façon à produire une seule structure de phase largement désordonnée, matériau dans le cas duquel au moins deux matières différentes sont simultanément capables de subir un processus exothermique auto-entretenu, ce qui permet la production d'une structure plus ordonnée quand le matériau est soumis à de la chaleur.

2. Matériau pyrotechnique tel que revendiqué à la revendication 1, dans lequel les au moins deux matières différentes sont conjointement capables de subir une réaction chimique exothermique auto-entretenue quand ce matériau est soumis à de la chaleur.

3. Matériau pyrotechnique tel que revendiqué à la revendication 2, comprenant deux matières différentes qui jouent respectivement le rôle d'une matière donneuse d'électrons et d'une matière acceptant les électrons.

4. Matériau pyrotechnique, tel que revendiqué à la revendication 3, dans lequel la matière donnant des électrons est un métal de transition, et la matière acceptant les électrons est choisie parmi des matières des Groupes IIIB et IVB (notation de l'Union Internationale de Chimie Pure et Appliquée, UICPA).

5. Matériau pyrotechnique tel que revendiqué à la revendication 1, dans lequel les au moins deux matières différentes sont conjointement capables, quand elles sont soumises à du chauffage, de subir une transition chimique exothermique auto-entretenue pour parvenir à une structure de réseau plus ordonnée.

6. Matériau pyrotechnique tel que revendiqué à la revendication 5, dans lequel les différentes matières comprennent une première matière et au moins une autre matière soluble dans la première matière à l'état solide.

7. Matériau pyrotechnique, tel que revendiqué dans l'une quelconque des revendications précédentes, comprenant en outre un substrat sur lequel sont déposées les au moins deux matières différentes.

8. Train pyrotechnique, comprenant le matériau pyrotechnique tel que revendiqué à la revendication 7.

9. Procédé de fabrication du matériau pyrotechnique de la revendication 1, comprenant les étapes consistant à :
choisir au moins deux matières différentes qui sont conjointement capables, quand on les soumet à du chauffage, de subir un processus exothermique auto-entretenu ;
déposer simultanément en phase vapeur les au moins deux matières différentes sur un substrat.

10. Procédé de fabrication d'un matériau pyrotechnique tel que revendiqué à la revendication 9, dans lequel les au moins deux matières différentes sont déposées en phase vapeur par projection par pulvérisation électrique à l'aide d'un magnétron déséquilibré.

11. Procédé de fabrication d'un train pyrotechnique, comprenant les étapes de la revendication 9 ou de la revendication 10, et comprenant en outre l'étape consistant à attaquer sélectivement la couche réactive déposée, de sorte que les régions restantes de cette couche fournissent une configuration voulue de trajets de réaction sur le substrat.

12. Procédé de fabrication d'un train pyrotechnique, comprenant les étapes de la revendication 9 ou de la revendication 10, et comprenant en outre l'étape consistant à masquer sélectivement le substrat avant le dépôt de la couche réactive, de façon à conférer, grâce au masquage, une configuration souhaitée de trajets de réaction sur le substrat.
